# EUROPÄISCHE PATENTSCHRIFT

(11) **EP 2 165 006 B1**
(45) Veröffentlichungstag und Bekanntmachung des Hinweises auf die Patenterteilung: **12.03.2014**
(21) Anmeldenummer: 08760984.8
(22) Anmeldetag: 13.06.2008
(51) Int. Cl.: C23C 16/458, C30B 25/12, H01L 21/687, C30B 25/10, C23C 16/46

(54) **VORRICHTUNG ZUM BESCHICHTEN VON AUF EINEM SUSZEPTOR ANGEORDNETEN SUBSTRATEN**
DEVICE FOR COATING SUBSTRATES DISPOSED ON A SUSCEPTOR
DISPOSITIF D'ENDUCTION DE SUBSTRATS PLACÉS SUR UN SUSCEPTEUR

(30) Priorität: 15.06.2007 DE 102007027704
(43) Veröffentlichungstag der Anmeldung: 24.03.2010
(73) Patentinhaber: Aixtron SE, 52134 Herzogenrath (DE)
(72) Erfinder: KÄPPELER, Johannes, 52146 Würselen (DE); BOYD, Adam, B-4720 Kelmis (BE); SAYWELL, Victor, Suffolk IP31 2SW (GB); MULDER, Jan, NL-5627 TN Eindhoven (NL); FERON, Olivier, Hsinchu (TW)
(74) Vertreter: Rieder, Hans-Joachim
(86) Internationale Anmeldenummer: PCT/EP2008/057452
(87) Internationale Veröffentlichungsnummer: WO 2008/152126

(56) Entgegenhaltungen:
- WO-A-02/097867
- DE-A1-102005 056 536
- US-A- 5 591 269

## Beschreibung

Die Erfindung betrifft eine Vorrichtung zum Beschichten von Substraten mit einer in einem Reaktorgehäuse angeordneten Prozesskammer und einem darin angeordneten, zweiteiligen, im Wesentlichen topfförmigen Suszeptor, welcher mit seinem eine ebene Platte aufweisenden Topfboden ein Suszeptoroberteil und mit seiner Topfseitenwandung ein Suszeptorunterteil ausbildet, wobei die äußere Seite der Platte des Suszeptoroberteils nach oben zur Prozesskammer weist und eine Auflagefläche für mindestens ein Substrat ausbildet, das Suszeptoroberteil mit seinem Rand auf einem Stirnrand des Suszeptorunterteils aufliegt, das Suszeptorunterteil von einem Suszeptorträger abgestützt wird und unterhalb der Platte Heizzonen zum Aufheizen des Suszeptoroberteils angeordnet sind.

Eine gattungsgemäße Vorrichtung wird von der US2004/0226515 A1 beschrieben. In einer Prozesskammer befindet sich ein Suszeptor in Form eines auf dem Kopf stehenden Topfes. Die Bodenplatte des Topfes bildet die Auflagefläche für die Substrate. Unterhalb der Bodenfläche befindet sich eine Heizung.

Aus der DE 102005056536 A1 ist eine Vorrichtung bekannt, bei der der Suszeptor aus einem einzigen Graphitteil besteht. Er besitzt die Form eines Topfes, wobei die nach außen weisende Wandung des Topfbodens eine Auflagefläche für Substrate ausbildet. Diese Topfaußenseite bildet den Boden einer Prozesskammer, deren Decke von einem Gaseinlassorgan ausgebildet wird. Innerhalb der Topföffnung des Suszeptors befindet sich eine Heizung, um die Oberfläche des Suszeptors auf eine Prozesstemperatur aufzuheizen, die 1600° C betragen kann. Aus der DE 102006018515 A1 ist ein Reaktorgehäuse mit darin angeordneter Prozesskammer bekannt, bei der ein ringförmiger Suszeptor auf einem ringförmigen Kragen aufliegt.

Aus der WO2004/079043 A2 ist ein Suszeptor für eine Beschichtungsanlage bekannt, welcher aus mehreren Teilen besteht, welche eine hohe thermische Leitfähigkeit besitzen.

Aus der US 5,480,489 ist ein CVD-Reaktor bekannt mit einem mehrteiligen Suszeptor zur Aufnahme von Substraten. Der Kontaktabschnitt für das Substrat des Suszeptors besteht aus Graphit.

Die US 2006/0057826 A1 beschreibt einen Suszeptor mit einer Aussparung im rückwärtigen Bereich, in welchen ein Thermoelement ragt.

Die US 5,091,208 zeigt einen mehrteiligen Suszeptor in einem CVD-Reaktor, wobei der Suszeptor eine zentrale Öffnung aufweist, in die ein Temperaturmessfühler hineinragt.

Die US 5, 552,124 beschreibt ebenfalls einen mehrteiligen Suszeptor mit einer Öffnung, in die ein Stift ragen kann.

Aus der JP 06020969 A ist ein zylindrischer Suszeptor bekannt, welcher aus Graphit besteht.

Aus der US 5,591,269 ist eine Vorrichtung bekannt, bei der ein Suszeptor auf seiner Unterseite einen zylindrischen Fortsatz mit einer Stirnseitenöffnung aufweist. In der Stirnseitenöffnung steckt ein Thermoelement.

Die WO02/097867 beschreibt eine Vorrichtung bestehend aus einem Tragkörper und einem darauf gelagerten drehangetriebenen Substrathalter. Tragkörper und Substrathalter sind als Ringe ausgebildet.

Bei CVD-Anlagen, die zum Stand der Technik gehören, kann der Durchmesser der im Wesentlichen kreisförmigen Auflagefläche für die Substrate größer als 300mm sein. Als Heizung kann eine Induktionsspirale oder ein Widerstandsdraht verwendet werden. Es sind mehrere Heizzonen in unterschiedlichen Radialabschnitten möglich. Der Suszeptor ist mit seiner Topföffnung nach unten im Reaktorgehäuse derartig angeordnet, dass er sich mit einer der Seitenwandung des topfförmigen Körpers zugeordneten Stützflanke auf einem Suszeptorträger abstützen kann. Der Suszeptorträger kann von einem Quarzrohr gebildet sein. Letzteres kann drehangetrieben werden, so dass sich die Auflagefläche für die Substrate relativ gegenüber dem Gaseinlassorgan drehen kann. Auf der Auflagefläche liegt eine Vielzahl von Substraten in unterschiedlichen Radialabständen zum Zentrum. Es besteht das verfahrenstechnische Problem, die Auflagefläche für die Substrate auch im Randbereich auf die gewünschte Depositionstemperatur zu bringen, wobei der laterale Temperaturgradient auf der Auflagefläche möglichst bis in den Randbereich sehr gering ist.

Die Beschichtung der auf dem Suszeptor aufliegenden Substrate erfolgt mittels durch das Gaseinlassorgan in die Prozesskammer eingeleiteter Gase. Diese zerfallen entweder in der Gasphase oder bei In-Kontakt-Treten mit der Substratoberfläche, um auf der Substratoberfläche insbesondere unter Ausbildung einer kristallinen Schicht zu kondensieren. Für das Abscheiden homogener Schichten ist nicht nur ein homogenes Temperaturprofil des Suszeptors erforderlich. Es sind auch ansonsten von Run-zu-Run gleiche Ausgangsbedingungen erforderlich. Um diese bereitzustellen, wird der Suszeptor von Zeit zu Zeit der Prozesskammer entnommen, um ihn außerhalb des Reaktorgehäuses zu reinigen.

Der Erfindung liegt die Aufgabe zugrunde, eine gattungsgemäße Vorrichtung gebrauchsvorteilhaft weiterzubilden.

Gelöst wird die Aufgabe durch die in den Ansprüchen angegebene Erfindung, wobei die Ansprüche 2 bis 11 vorteilhafte Weiterbildungen des Anspruchs 1 und die Ansprüche 13 bis 15 vorteilhafte Weiterbildungen des Anspruchs 12 betreffen.

Zunächst und im Wesentlichen ist vorgesehen, dass der Suszeptor aus zwei voneinander trennbaren Teilen aus demselben Werkstoff besteht. Ein unterer, ringförmiger Teil des Suszeptors bildet die Stützflanke aus, mit der sich der Suszeptor auf dem Suszeptorträger abstützt. Dieser untere Teil des Suszeptors bildet bevorzugt auch den überwiegenden Teil der Seitenfläche des topfförmigen Gesamtkörpers aus. Der obere Teil des Suszeptors bildet zumindest den gesamten Topfboden, also die gesamte Auflagefläche für die Substrate, aus. Wesentlich ist darüber hinaus, dass die Fuge zwischen dem Rand des Suszeptoroberteils mit dem Stirnrand des Suszeptorunterteils als Wärmeleitungsbarriere ausgebildet ist. Dies hat zur Folge, dass die Wärme, die im Suszeptoroberteil von der Heizung zugeführt wird, nicht oder nur zu einem geringen Maße über Wärmeleitung in den unteren Suszeptorteil abfließt. In einer Weiterbildung der Erfindung ist vorgesehen, dass die den Boden der Prozesskammer ausbildende Oberseite des Suszeptors unter Ausbildung einer Rundung in die Seitenwandung übergeht. Der Rundungsabschnitt sowie ein Abschnitt der Seitenwandung kann dabei dem oberen Teil des Suszeptors zugeordnet sein. Die Rundung besitzt einen Rundungsradius, der 15 mm betragen kann. Bevorzugt liegt der Radius in einem Bereich zwischen 10 mm und 20 mm. Die Innenwandung des Topfes besitzt im Übergangsbereich zwischen Topfboden und Topfseitenwandung ebenfalls eine Rundung. Der Rundungsradius dieser Innenrundung ist geringer als der Rundungsradius der Außenrundung und kann 10 mm betragen. Auch hier kann der Radius in einem gewissen Wertebereich von 5 mm bis beispielsweise 15 mm liegen. Unterhalb der Bodenplatte, die von dem Suszeptoroberteil gebildet ist, befinden sich mehrere geheizte Zonen. Die Zonen besitzen im Wesentlichen eine Rotationssymmetrie und haben unterschiedliche Abstände zum Zentrum des Suszeptors. Die Heizungen können von Widerstandsdrähten gebildet sein. Diese sind dann spiralförmig angeordnet. Im Randbereich, d.h. in der Nachbarschaft der Innenrundung, liegen die einzelnen Windungen der Widerstandsheizung dichter nebeneinander als im Bereich unterhalb des Zentralbereichs des Suszeptors. In einer Variante der Erfindung besitzt das Suszeptoroberteil keinen Seitenwandungsabschnitt, sondern liegt unter Ausbildung eines flachen, kreisscheibenförmigen Deckels auf der Stirnrandflanke eines rohrförmigen unteren Suszeptorteiles auf. Im Bereich der Auflagezone, also im Randbereich, besitzt das Suszeptoroberteil eine geneigte, ringförmige Randfläche, die ebenso wie die Verrundung der ersten Variante zu einer Verringerung des lateralen Temperaturgradienten auf der zum Gaseinlassorgan weisenden Außenseite des Suszeptors führt. Zufolge der geneigten Randfläche ist die Materialstärke der Suszeptorplatte im Randbereich etwas vermindert. Die der geneigten Randfläche gegenüberliegende Breitseitenwandung des Suszeptoroberteils kann eine Ringstufe ausbilden, mit der sich das Suszeptoroberteil auf dem Suszeptorunterteil formschlüssig abstützt. Bei der ersten Variante kann ebenfalls eine geringfügige Stufe vorgesehen sein, um eine Formschlussverbindung zwischen den beiden Suszeptorteilen auszubilden. Alternativ dazu können aber auch Vorsprünge vorgesehen sein, die beispielsweise dem Suszeptorunterteil zugeordnet sind und die in entsprechende Taschen, die beispielsweise dem Suszeptoroberteil zugeordnet sind, eingreifen. Der Suszeptor ist drehangetrieben. Der Antrieb erfolgt bevorzugt über den Suszeptorträger derartig, dass sich der Suszeptor gegenüber den Zonen-Heizungen dreht. Inhomogenitäten werden dadurch zeitlich ausgemittelt.

Mit den zuvor genannten konstruktiven Maßnahmen ist es möglich, den Temperaturdifferenzbereich einer auf 1600° C aufgeheizten Suszeptorplatte mit einem Durchmesser von bis zu 400 mm unter 80° C zu halten. Mit dem kantenverrundeten Suszeptoroberteil ist sogar ein Temperaturdifferenzbereich von lediglich weniger als 60° C erreichbar. Mit den konstruktiven Maßnahmen ist auch die Fertigung eines derartigen Suszeptors vereinfacht worden. Er kann aus zwei Teilen gefertigt werden, wobei ein Teil die Auflagefläche für die Substrate ausbildet und ein anderer Teil einen ringförmigen Umgebungsbereich. Die erfindungsgemäße Ausgestaltung vereinfacht darüber hinaus das Reinigen des Suszeptors. Da der Boden von der Topfwand trennbar ist, braucht zum Reinigen lediglich der Topfboden von der Topfwand innerhalb des Reaktors getrennt zu werden. Es wird dann lediglich der Topfboden zwecks Reinigung aus dem Reaktor gebracht. Die am Rande vorgesehene Verrundung bringt eine Vergleichmäßigung des Temperaturprofils der Suszeptorfläche.

Besteht zwischen der Stützflanke des oberen Suszeptorteiles und dem Stirnrand des unteren Suszeptorteiles ein geringer Spalt, so bildet sich dort eine Temperatursprungstelle aus. Dies hat zur Folge, dass der Randbereich des oberen Suszeptorteiles eine geringere Abkühlung durch Wärmeleitung erfährt. Der Spalt braucht lediglich 100 µm zu betragen.

Eine weitere, auch eigenständigen Charakter aufweisende Weiterbildung besteht darin, bei einer Vorrichtung zum Beschichten von Substraten mit einem in einem Reaktorgehäuse angeordneten Suszeptor eine Aufnahmeöffnung für ein Thermoelement, welche sich an der Unterseitenfläche des Suszeptors befindet, weiterzubilden. Diesbezüglich schlägt die Erfindung vor, dass die Aufnahmeöffnung eine Mulde ist. Diese wird von einem von der Unterseitenfläche des Suszeptors abragenden Ringwulst gebildet. Der Boden der Mulde liegt im Wesentlichen in derselben Ebene, in der auch die den Ringwulst umgebende Unterseitenfläche liegt. Dies hat zur Folge, dass die Materialstärke der Suszeptorbodenplatte auch im Bereich des Thermoelementes genauso groß ist, wie in dem Umgebungsbereich. Das Thermoelement liegt vor Kopf eines Thermoelementhalters, der sich bis in die Mulde hinein erstreckt. Der Ringwulst bildet nicht nur einen Strahlungsschirm. Er verhindert auch eine Messverfälschung durch konvektierende Gase. Bevorzugt liegt das Thermoelement in berührendem Kontakt mit dem Muldenboden. Das Thermoelement kann aber auch einen geringen Abstand zum Muldenboden besitzen.

Ausführungsbeispiele der Erfindung werden nachfolgend anhand beigefügter Zeichnungen erläutert. Es zeigen:
- Fig. 1: einen Querschnitt durch die wesentlichen, die Prozesskammer in einem Reaktorgehäuse bildenden Aggregate eines ersten Ausführungsbeispiels,
- Fig. 2: ein Suszeptorunterteil in der Draufsicht,
- Fig. 3: einen Schnitt gemäß der Linie III - III in Fig. 2,
- Fig. 4: das Suszeptorunterteil in der Seitenansicht,
- Fig. 5: ein Suszeptoroberteil in der Draufsicht,
- Fig. 6: ein Suszeptoroberteil in der Unteransicht,
- Fig. 7: einen Schnitt gemäß der Linie VII - VII in Fig. 5,
- Fig. 8: ein zweites Ausführungsbeispiel der Erfindung gemäß Fig. 1, und
- Fig. 9: eine Ausschnittsvergrößerung gemäß Ausschnitt IX in Fig. 1.

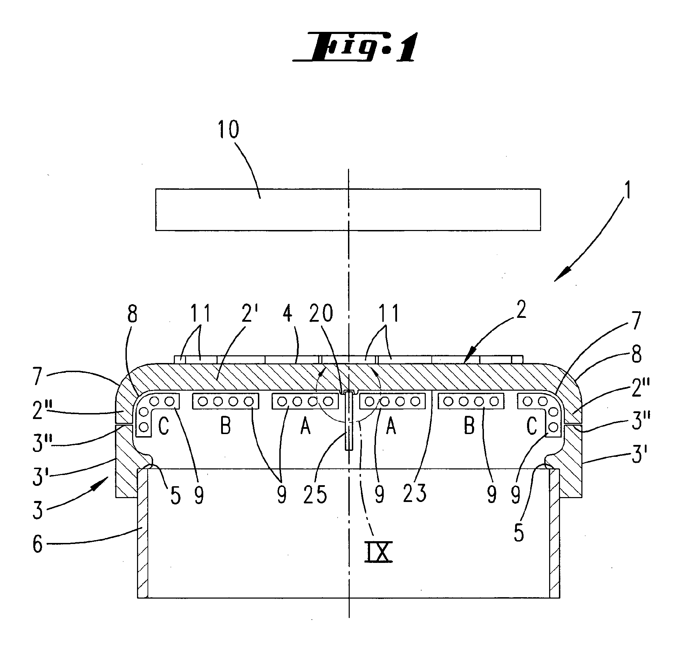

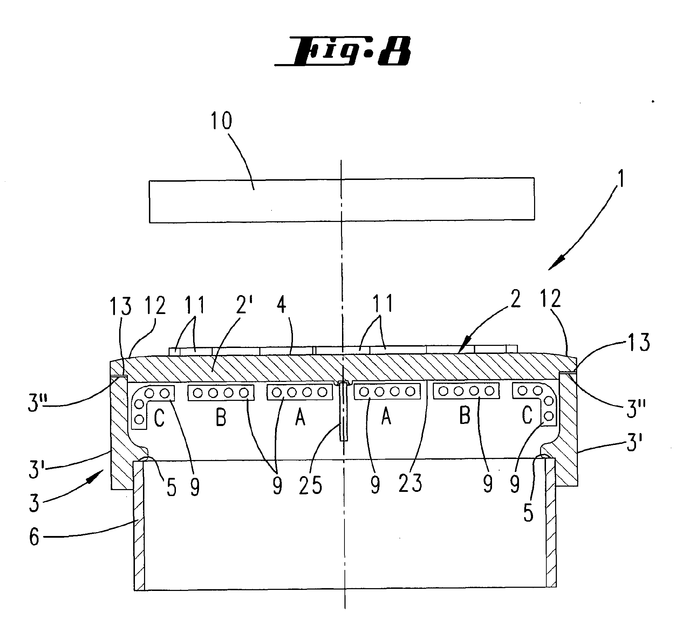

In den Figuren sind nur die zur Erläuterung der Erfindung wesentlichen Aggregate einer Vorrichtung zum Beschichten von Substraten dargestellt. In einem nicht dargestellten Reaktorgehäuse befindet sich eine Prozesskammer 1. Deren Decke wird von einem Gaseinlassorgan ausgebildet, mit dem verschiedene Prozessgase in die Prozesskammer 1 eingeleitet werden. In den Figuren 1 und 8 ist es mit der Bezugsziffer 10 angedeutet. Das Gaseinlassorgan 10 kann gekühlt oder beheizt werden. Es kann eine Vielzahl von duschkopfartig angeordneten Gasaustrittsöffnungen aufweisen, durch die die Prozessgase entweder gemeinsam oder getrennt voneinander in die Prozesskammer 1 eingeleitet werden.

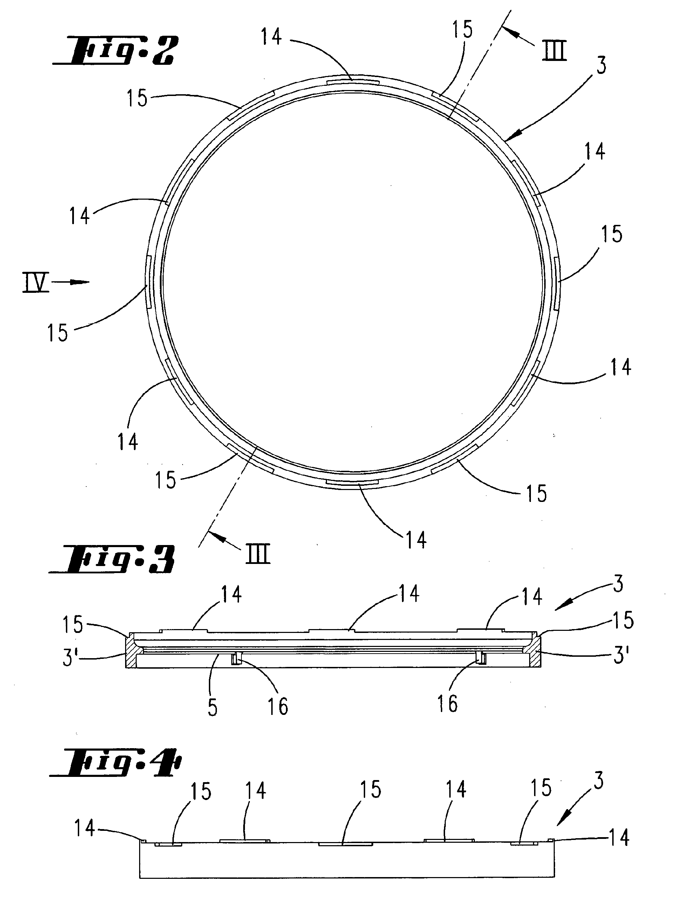

Der Boden der Prozesskammer 1 bildet eine Auflagefläche 4 für eine Vielzahl von Substraten 11 aus, die beschichtet werden sollen. In den Figuren 1 und 8 sind die Substrate 1 als auf der zur Prozesskammer 1 weisenden Oberseite des Suszeptors 2, 3 dargestellt. Die Substrate können aber auch in der Umrisskontur der Substrate angepassten Vertiefungen der Oberseite liegen. Die Auflagefläche, die ggf. von den Böden der nicht dargestellten Vertiefungen gebildet sein kann, ist die zum Gaseinlassorgan 10 weisende Breitseitenfläche eines Suszeptoroberteiles 2, welches aus Graphit besteht. Das Suszeptoroberteil 2 liegt mit einer ringförmigen Auflagefläche, die sich an einem Seitenwandungsabschnitt 2" abstützt, auf einem Stirnrand 3" eines zweiten Suszeptorteiles 3 auf. Das zweite Suszeptorteil 3 bildet ein Suszeptorunterteil aus und ist ebenfalls aus Graphit gefertigt. Das Suszeptorunterteil 3 besitzt eine im Wesentlichen ringförmige bzw. rohrförmige Gestalt. Von der Innenwandung des zweiten Suszeptorteiles 3 ragt radial einwärts ein Ringvorsprung ab. Dieser bildet nicht nur die in der Fig. 4 mit der Bezugsziffer 16 bezeichneten Stege, sondern auch eine Auflagefläche 5 aus, mit der sich das Suszeptorunterteil 3 auf einer Stirnfläche eines Quarzrohres abstützt, welches den Suszeptorträger 6 ausbildet. Die Stirnringfläche des Suszeptorträgers 6 kann Aussparungen aufweisen, in die die Stege 16 einrasten, so dass das Suszeptorunterteil 3 drehfest mit dem Suszeptorträger 6 verbunden ist. Der Stirnrandabschnitt des Suszeptorträgers 6 ragt in die Höhlung des Suszeptorunterteils 3 hinein, so dass zwischen Suszeptordrehträger 6 und Suszeptorunterteil eine Formschlussverbindung gewährleistet ist. Der Suszeptorträger 6 kann drehangetrieben werden, so dass sich der Suszeptor 2, 3 gegenüber dem Gaseinlassorgan 10 drehen kann.

Wie den Figuren 3 bis 4 zu entnehmen ist, ragen von dem Stirnrand 3", auf dem sich das Suszeptoroberteil 2 abstützt, Vorsprünge 14 nach oben. Radial versetzt zu den Vorsprüngen 14 bildet der obere Stirnrand 3" auch Taschen 15 aus.

Zu den Vorsprüngen 14, die der Innenwandung des Suszeptorunterteils 3 benachbart sind, korrespondieren Taschen 18 des Suszeptoroberteils 2. In diese Taschen 18 greifen die Vorsprünge 14 ein, wenn das Suszeptoroberteil 2 auf dem Suszeptorunterteil 3 aufliegt. Hierdurch ist das Suszeptoroberteil 2 formschlüssig mit dem Suszeptorunterteil 3 verbunden.

Die beiden Suszeptorteile 2, 3 bilden zusammen einen im Wesentlichen topfförmigen Körper aus. Innerhalb des Topfvolumens befindet sich, der Bodenplatte 2' benachbart, eine aus mehreren Widerstandsdrahtspiralen bestehende Heizung. Es sind verschiedene Heizzonen A, B, C vorgesehen, die jeweils verschiedene Radialabstände zum Zentrum des Suszeptors 2, 3 besitzen. Mit der radial äußersten Heizzone C wird der Randbereich des Suszeptoroberteils 2 aufgeheizt. Hier besitzen die Heizwicklungen einen geringeren Abstand zueinander als im Zentralbereich.

Das in den Figuren 1 bzw. 5 bis 7 dargestellte Suszeptoroberteil besitzt eine ebene Auflagefläche 4 für die Substrate, die von der Breitseitenwandung der Bodenplatte 2' ausgebildet wird. Im Bereich des kreisförmigen Randes geht diese Auflagefläche 4 unter Ausbildung einer Außenrundung 7 in einen Seitenwandungsabschnitt 2" des Suszeptoroberteils 2 über. Der Rundungsradius der Außenrundung 7 beträgt etwa 15 mm. Auf seiner Innenseite besitzt das Suszeptoroberteil 2 ebenfalls eine Kantenverrundung 8, die der Außenrundung 7 gegenüberliegt. Der Rundungsradius dieser Innenverrundung 8 beträgt etwa 10 mm. Im Bereich des Seitenwandungsabschnittes 2" ist die Materialstärke des Suszeptoroberteils 2 geringer als im Bereich der Bodenplatte 2'.

Die Außenfläche der Seitenwandung 2" geht bündig in die Außenwandung 3"' des Suszeptorunterteils über.

Bei dem in der Fig. 8 dargestellten zweiten Ausführungsbeispiel bildet das Suszeptorunterteil 3 eine rohrförmige Manschette aus. Auch hier besitzt der aus zwei Teilen 2, 3 bestehende Suszeptor eine Rotationssymmetrie. Das Suszeptoroberteil 2 ist als kreisscheibenförmige Platte 2' ausgebildet. Die Auflagefläche für die Substrate 4 verläuft im gesamten Zentralbereich auf einer Ebene. Im Bereich des Randes der Platte 2' befindet sich eine geneigte Randfläche 12. Hierdurch vermindert sich die Materialstärke des Suszeptoroberteils 2 im Randbereich.

Gegenüberliegend zur geneigten Randfläche 12 bildet die Unterseite der Bodenplatte 2' eine Stufe 13 aus, mit der das Suszeptoroberteil 2 auf der Stirnrandkante 3" des Suszeptorunterteiles 3 aufliegt.

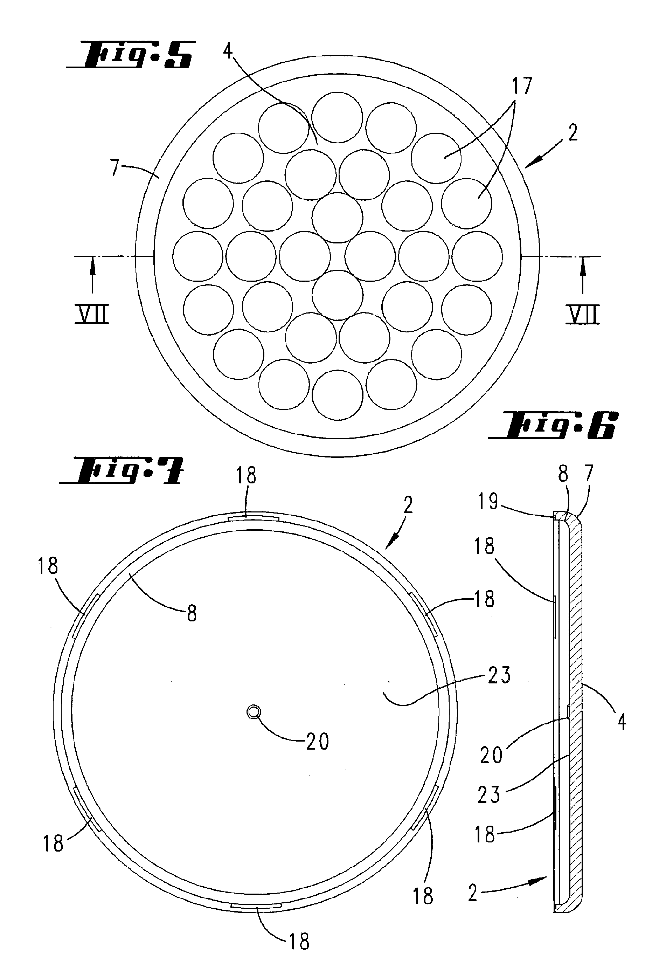

Auch bei diesem Ausführungsbeispiel können die in der Fig. 5 dargestellten und mit der Bezugsziffer 17 bezeichneten Vertiefungen vorgesehen sein, in die jeweils ein Substrat 11 eingelegt werden kann.

Zwischen dem Stirnrand des Seitenwandungsabschnittes 2" des Suszeptoroberteiles 2 und der Stirnrandkante 3" des Suszeptorunterteiles 3 kann ein geringfügiger Spalt in der Größenordnung zwischen 50 µm und 200 µm vorhanden sein. Das Suszeptoroberteil 2 kann sich lediglich lokal gegebenenfalls unterer Zwischenlage eines Isolators auf dem Suszeptorunterteil abstützen. Es reicht aus, wenn der Spalt zwischen Suszeptoroberteil 2 und Suszeptorunterteil 3 größer als 50 µm ist, um eine ausreichende Verminderung des Wärmeabflusses durch Wärmeleitung vom Suszeptoroberteil 2 hin zum Suszeptorunterteil 3 zu unterbinden. Zur Erzeugung eines homogenen Temperaturprofiles, also einen flach verlaufenden lateralen Temperaturgradienten auf der Oberfläche dient darüber hinaus die dichtere Anordnung der Heizelemente 9 im Randbereich des Suszeptoroberteiles 2 rückwärtig der äußeren Krümmung 8. Die verwendete Heizelemente 9 sind so ausgelegt, dass ihre Heizleistung und insbesondere Strahlungsleistung im Randbereich, also in der Heizzone C größer ist, als im Zentrumsbereich, also in der Zone A.

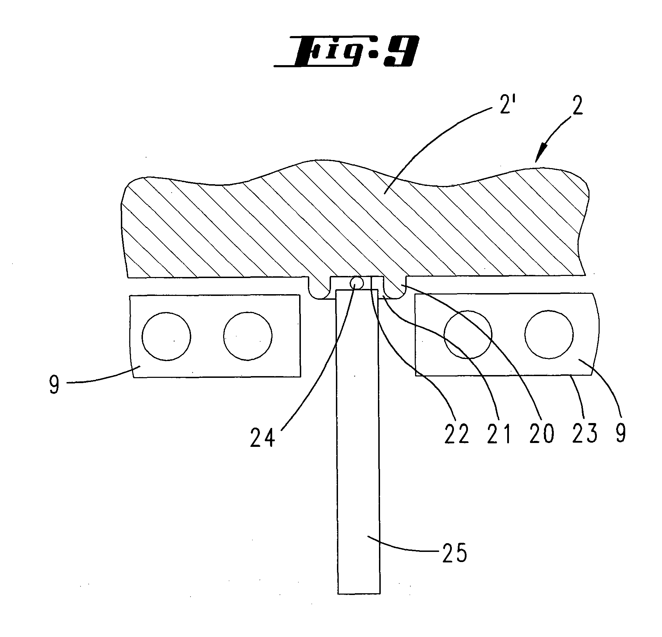

Die Temperatur des Suszeptors und insbesondere die Temperatur der Bodenplatte 2' des Suszeptors, wie er in den zuvor beschriebenen Ausführungsbeispielen beschrieben worden ist, kann mit einem oder mehreren Thermoelementen 24 gemessen werden. Insbesondere im Zentralbereich ist eine Temperaturmessstelle vorgesehen. Diese ist in der Fig. 9 vergrößert dargestellt. Ein von der Rückseitenfläche 23 der Bodenplatte 2' des Suszeptoroberteiles 2 abragender Ringwulst 20 bildet eine Mulde 21 aus. Der Boden 22 der Mulde 21 verläuft auf demselben Niveau wie die Rückseitenfläche 23. Muldenboden 22 und Rückseitenfläche 23 verlaufen somit in derselben Ebene.

Das Thermoelement 24 wird von einem insbesondere keramischen Thermoelementhalter 25 getragen. Es befindet sich vor dessen Stirnfläche und in berührender Anlage am Muldenboden 22. Der das Thermoelement 24 tragende Stirnabschnitt des Thermoelementhalters 25 ragt über den Scheitel des Ringwulstes 20 hinaus in die Mulde 21.

Zufolge dieser Ausgestaltung ist die Materialstärke des Suszeptors 2 im Bereich der Temperaturmessstelle identisch mit der Materialstärke im Umgebungsbereich, so dass die Messstelle keinen Einfluss auf den Verlauf der Oberflächentemperatur der Auflagefläche 4 ausübt.

Diese Anordnung des Thermoelementes ist darüber hinaus auch förderlich, wenn das Suszeptoroberteil 2 zum Zwecke der Reinigung aus dem Reaktorgehäuse entnommen werden muss. Das Suszeptoroberteil 2 wird dabei geringfügig angehoben und dabei vom Suszeptorunterteil 3 getrennt. Bei der Reinigung des Suszeptoroberteiles 2, die außerhalb des Reaktorgehäuses stattfindet, verbleibt das Suszeptorunterteil 3 in der Prozesskammer. Das zu reinigende Suszeptoroberteil 2 kann gegen ein gereinigtes Suszeptoroberteil ausgetauscht werden, welches auf den Stirnrand 3" des Suszeptorunterteils 3 aufgelegt werden kann. Die nach oben ragenden Vorsprünge 14 des Stirnrandes 3" rasten dabei in die zugeordneten Taschen 18 des Suszeptoroberteils 2 ein.

Die Höhe der Vorsprünge 14 entspricht im Wesentlichen der Höhe des Ringwulstes 20.

## Patentansprüche

1. Vorrichtung zum Beschichten von Substraten mit einer in einem Reaktorgehäuse angeordneten Prozesskammer (1) und einem darin angeordneten, zweiteiligen, im Wesentlichen topfförmigen Suszeptor (2, 3), welcher mit seinem eine ebene Platte (2') aufweisenden Topfboden ein Suszeptoroberteil (2) und mit seiner Topfseitenwandung ein Suszeptorunterteil (3) ausbildet, wobei die äußere Seite (4) der Platte (2') des Suszeptoroberteils (2) nach oben zur Prozesskammer (1) weist und eine Auflagefläche für mindestens ein Substrat ausbildet, das Suszeptoroberteil (2) mit seinem Rand auf einem Stirnrand (3") des Suszeptorunterteils (3) aufliegt, das Suszeptorunterteil (3) von einem Suszeptorträger (6) abgestützt wird, und unterhalb der Platte (2') Heizzonen (A,B,C) zum Aufheizen des Suszeptoroberteils (2) angeordnet sind, **dadurch gekennzeichnet, dass** das Suszeptoroberteil (2) getrennt vom Suszeptorunterteil (3) aus der Prozesskammer (1) entnehmbar ist, und die Fuge zwischen dem Rand des Suszeptoroberteils (2) und dem Stirnrand (3") des Suszeptorunterteils (3) als eine Wärmeleitungsbarriere ausgebildet ist.

2. Vorrichtung nach Anspruch 1, **dadurch gekennzeichnet, dass** die beiden Suszeptorteile (2,3) aus einem identischen Werkstoff und insbesondere aus Graphit bestehen.

3. Vorrichtung nach einem der vorhergehenden Ansprüche, **dadurch gekennzeichnet, dass** die den Boden der Prozesskammer (1) bildende Oberseite (4) des Suszeptoroberteiles (2) unter Ausbildung einer Rundung (7) in einen Seitenwandungsabschnitt (2") übergeht.

4. Vorrichtung nach einem der vorhergehenden Ansprüche, **gekennzeichnet durch** mehrere unterhalb der im Wesentlichen einen kreisförmigen Grundriss aufweisenden Platte (2') des oberen Suszeptoroberteiles (2) in verschiedenen Abständen zum Zentrum angeordnete insbesondere konzentrisch zu einem Zentrum angeordnete Heizzonen (A, B, C).

5. Vorrichtung nach einem der vorhergehenden Ansprüche, **dadurch gekennzeichnet, dass** die radial äußerst liegenden Heizzone (C) eine höhere Wärmeleistung entfaltet als die inneren Heizzonen (A,B) und insbesondere die Heizzonen (A,B,C) von Widerstandsdrähten (9) gebildet sind, die im Bereich des Randes enger zueinander liegen als im Zentralbereich.

6. Vorrichtung nach einem der vorhergehenden Ansprüche, **gekennzeichnet durch** eine der Außenrundung (7) gegenüberliegende Innenrundung (8), wobei der Krümmungsradius der Innenrundung (8) kleiner ist als der Krümmungsradius der Außenrundung (7).

7. Vorrichtung nach einem der vorhergehenden Ansprüche, **dadurch gekennzeichnet, dass** die Wandstärke der Seitenwandung (2") des Suszeptoroberteils (2) geringer ist als die Wandstärke der Platte (2').

8. Vorrichtung nach einem der vorhergehenden Ansprüche, **gekennzeichnet durch** einen ringförmigen und geneigten Randbereich (12) des Suszeptoroberteiles (2).

9. Vorrichtung nach einem der vorhergehenden Ansprüche, **gekennzeichnet durch** eine vom Rand der Rückseitenfläche (23) der vom Suszeptoroberteil (2) ausgebildeten Platte (2') ausgebildeten Stufe (13), mit der sich das Suszeptoroberteil (2) auf einem Stirnrand (3") des Suszeptorunterteiles (3) abstützt.

10. Vorrichtung nach einem der vorhergehenden Ansprüche, **dadurch gekennzeichnet, dass** die Fuge zwischen Suszeptoroberteil (2) und Suszeptorunterteil (3) eine Spaltweite von mindestens etwa 100 µm besitzt.

11. Vorrichtung nach einem der vorhergehenden Ansprüche, **dadurch gekennzeichnet, dass** der Suszeptorträger (6) drehangetrieben ist, um den topfförmigen Suszeptor (2, 3) gegenüber der ortsfesten Heizung drehanzutreiben.

12. Vorrichtung nach einem der vorhergehenden Ansprüche aufweisend zumindest eine Aufnahmeöffnung für zumindest ein Thermoelement (24), **dadurch gekennzeichnet, dass** die mindestens eine Aufnahmeöffnung eine von einem von der Unterseitenfläche (23) abragenden Ringwulst (20) gebildeten Mulde (21) ist, deren Boden (22) im Wesentlichen in der von der Unterseitenfläche (23) gebildeten Ebene liegt.

13. Vorrichtung nach Anspruch 12, **dadurch gekennzeichnet, dass** die Mulde (21) im Zentrum des Suszeptors (2) angeordnet ist.

14. Vorrichtung nach einem der Ansprüche 12 oder 13, **dadurch gekennzeichnet, dass** ein vor seiner Stirnfläche das Thermoelement (24) halternder Thermoelementhalter (25) bis über den äußeren Rand des Ringwulstes (20) in die Mulde (21) hineinragt.

15. Vorrichtung nach einem der Ansprüche 12 bis 14, **dadurch gekennzeichnet, dass** das Thermoelement (24) in Kontakt zum Muldenboden oder in einem geringen Abstand zum Muldenboden (21) liegt.

## Claims

1. Device for coating substrates, having a process chamber (1) which is disposed in a reactor housing and a two-part, substantially cup-like susceptor (2, 3) which is disposed in said process chamber, the susceptor forming a susceptor upper part (2) by way of its cup base, the cup base having a flat plate (2'), and the susceptor forming a susceptor lower part (3) by way of its cup side wall, the outer side (4) of the plate (2') of the susceptor upper part (2) facing upward toward the process chamber (1) and forming a bearing surface for at least one substrate, the susceptor upper part (2), by way of its edge, resting on an end edge (3") of the susceptor lower part (3), the susceptor lower part (3) being supported by the susceptor carrier (6), and heating zones (A, B, C) for heating the susceptor upper part (2) being disposed beneath the plate (2'), **characterized in that** the susceptor upper part (2) can be removed from the process chamber (1) separately from the susceptor lower part (3), and the joint between the edge of the susceptor upper part (2) and the end edge (3") of the susceptor lower part (3) is in the form of a barrier to the conduction of heat.

2. Device according to Claim 1, **characterized in that** the two susceptor parts (2, 3) comprise an identical material, in particular graphite.

3. Device according to one of the preceding claims, **characterized in that** the upper side (4) of the susceptor upper part (2), which upper side forms the base of the process chamber (1), merges with a side wall portion (2") so as to form a rounded portion (7).

4. Device according to one of the preceding claims, **characterized by** a plurality of heating zones (A, B, C) which are disposed beneath the plate (2'), the plate being substantially circular in plan view, of the upper susceptor upper part (2) at various distances from the center, and are in particular disposed concentrically with respect to a center.

5. Device according to one of the preceding claims, **characterized in that** the radially outermost heating zone (C) has a higher heating capacity than the inner heating zones (A, B) and, in particular, the heating zones (A, B, C) are formed by resistance wires (9) which are situated closer to one another in the region of the edge than in the central region.

6. Device according to one of the preceding claims, **characterized by** an inner rounded portion (8) which is opposite from the outer rounded portion (7), the radius of curvature of the inner rounded portion (8) being less than the radius of curvature of the outer rounded portion (7).

7. Device according to one of the preceding claims, **characterized in that** the wall thickness of the side wall (2") of the susceptor upper part (2) is less than the wall thickness of the plate (2').

8. Device according to one of the preceding claims, **characterized by** an annular and sloping edge region (12) of the susceptor upper part (2).

9. Device according to one of the preceding claims, **characterized by** a step (13) which is formed by the edge of the surface (23) of the rear side of the plate (2') that is formed by the susceptor upper part (2), said step supporting the susceptor upper part (2) on an end edge (3") of the susceptor lower part (3).

10. Device according to one of the preceding claims, **characterized in that** the joint between the susceptor upper part (2) and the susceptor lower part (3) has a gap width of at least approximately 100 µm.

11. Device according to one of the preceding claims, **characterized in that** the susceptor carrier (6) is rotationally driven, in order to drive the cup-like susceptor (2, 3) in rotation with respect to the stationary heater.

12. Device according to one of the preceding claims, comprising at least one accomodating opening for at least one thermal element (24),**characterized in that** the at least one accommodating opening is a recess (21) which is defined by an annular bead (20) that protrudes from the surface (23) of the lower side, the base (22) of said recess lying substantially in the plane formed by the surface (23) of the lower side.

13. Device according to Claim 12, **characterized in that** the recess (21) is disposed in the center of the susceptor (2).

14. Device according to one of Claims 12 and 13, **characterized in that** a thermocouple holder (25) which holds the thermocouple (24) in front of the end surface of the holder projects into the recess (21) to beyond the outer edge of the annular bead (20).

15. Device according to one of Claims 12 to 14, **characterized in that** the thermocouple (24) is in contact with the base of the recess or is at a short distance from the base of the recess (21).

## Revendications

1. Dispositif de revêtement de substrats, avec une chambre de réaction (1), déposée dans un boîtier de réacteur, et un suscepteur (2, 3) conformé selon une cuvette, et constitué de deux parties en étant disposé à l'intérieur de ladite chambre de réaction, lequel suscepteur forme avec son fond de cuvette comportant une plaque plane (2') une partie supérieure (2) du suscepteur et avec sa paroi de cuvette latérale une partie inférieure (3) du suscepteur, le côté extérieur (4) de la plaque (2') de la partie supérieure (2) du suscepteur pointant vers le haut en direction de la chambre de réaction (1) et formant une surface d'appui destinée à au moins un substrat, la partie supérieure (2) du suscepteur portant au niveau de son bord sur un bord frontal (3") de la partie inférieure (3) du suscepteur, la partie inférieure (3) du suscepteur étant supportée par un support de suscepteur (6), et des zones de chauffage (A, B, C) étant disposées au-dessous de la plaque (2') afin de chauffer la partie supérieure (2) du suscepteur, **caractérisé en ce que** la partie supérieure (2) du suscepteur peut être séparée de la partie inférieure (3) du suscepteur hors de la chambre de réaction (1), et la jonction située entre le bord de la partie supérieure (2) du suscepteur et du bord frontal (3") de la partie inférieure (3) du suscepteur est conformée en barrière de conduction thermique.

2. Dispositif selon la revendication 1, **caractérisé en ce que** les deux parties (2, 3) du suscepteur sont en une matière identique et en particulier en graphite.

3. Dispositif selon l'une des revendications précédentes, **caractérisé en ce que** le côté supérieur (4), formant le fond de la chambre de réaction (1), de la partie supérieure (2) du suscepteur se transforme en une portion de paroi latérale (2") en formant un arrondi (7).

4. Dispositif selon l'une des revendications précédentes, **caractérisé par** plusieurs zones de chauffage (A, B, C) disposées à différentes distances d'un centre et disposées notamment concentriquement au centre au-dessous de la plaque (2'), ayant sensiblement un tracé circulaire, de la partie supérieure (2) du suscepteur.

5. Dispositif selon l'une des revendications précédentes, **caractérisé en ce que** la zone de chauffage (C), se trouvant radialement le plus à l'extérieur, déploie une puissance thermique supérieure à celle des zones de chauffage intérieures (A, B) et notamment les zones de chauffage (A, B, C) sont formées par des fils de résistance (9) qui sont plus rapprochés l'un de l'autre dans la région du bord que dans la région centrale.

6. Dispositif selon l'une des revendications précédentes, **caractérisé par** un arrondi intérieur (8) opposé à l'arrondi extérieur (7), le rayon de courbure de l'arrondi intérieur (8) étant inférieur au rayon de courbure de l'arrondi extérieur (7).

7. Dispositif selon l'une des revendications précédentes, **caractérisé en ce que** l'épaisseur de la paroi latérale (2") de la partie supérieure (2) du suscepteur est inférieure à l'épaisseur de la plaque (2').

8. Dispositif selon l'une des revendications précédentes, **caractérisé par** une région de bord (12) annulaire et inclinée de la partie supérieure (2) du suscepteur.

9. Dispositif selon l'une des revendications précédentes, **caractérisé par** un gradin (13) qui est formé par le bord de la face latérale arrière (23) de la plaque (2') formée par la partie supérieure (2) du suscepteur et avec lequel la partie supérieure (2) du suscepteur porte sur un bord frontal (3") de la partie inférieure (3) du suscepteur.

10. Dispositif selon l'une des revendications précédentes, **caractérisé en ce que** la jonction entre la partie supérieure (2) du suscepteur et la partie inférieure (3) du suscepteur présente un interstice d'au moins 100 µm environ.

11. Dispositif selon l'une des revendications précédentes, **caractérisé en ce que** le support de suscepteur (6) est entraîné en rotation afin d'entraîner en rotation le suscepteur (2, 3) en forme de cuvette par rapport au dispositif de chauffage fixe.

12. Dispositif selon l'une des revendications précédentes comportant au moins une ouverture de réception destinée à au moins un thermocouple (24), **caractérisé en ce qu'**au moins une ouverture de réception est une cavité (21) qui est formée par un bourrelet annulaire (20) saillant de la surface latérale inférieure (23) et dont le fond (22) se trouve sensiblement dans le plan formé par la surface latérale inférieure (23).

13. Dispositif selon la revendication 12, **caractérisé en ce que** le bourrelet (21) est disposé au centre du suscepteur (2).

14. Dispositif selon l'une des revendications 12 ou 13, **caractérisé en ce qu'**un support de thermocouple (25) supportant le thermocouple (24) en avant de sa surface frontale, fait saillie dans la cavité (21) jusqu'au-dessus du bord extérieur du bourrelet annulaire (20).

15. Dispositif selon l'une des revendications 12 à 14, **caractérisé en ce que** le thermocouple (24) est en contact avec le fond de la cavité ou s'étendant à une faible distance du fond (21) de la cavité.
